# FASCICULE DE BREVET EUROPEEN

(11) **EP 0 702 453 B1**
(45) Date de publication et mention de la délivrance du brevet: **05.12.2001**
(21) Numéro de dépôt: 95202391.9
(22) Date de dépôt: 05.09.1995
(51) Int. Cl.: H03G 3/20

(54) **Circuit de commande automatique de gain et appareil muni du circuit**
Schaltung zur automatischen Verstärkungsregelung und Vorrichtung mit einer solchen Schaltung
Automatic gain control circuit and device provided with such a circuit

(30) Priorité: 13.09.1994 FR 9410906
(43) Date de publication de la demande: 20.03.1996
(73) Titulaire: Koninklijke Philips Electronics N.V., 5621 BA Eindhoven (NL)
(72) Inventeur: Guillaud, Jean-Michel, F-75008 Paris (FR); Martinez, Georges, F-75008 Paris (FR)
(74) Mandataire: Chaffraix, Jean

(56) Documents cités:
- EP-A- 0 176 303
- EP-A- 0 431 435
- WO-A-87/04877
- GB-A- 2 216 353
- PATENT ABSTRACTS OF JAPAN vol. 018 no. 180 (E-1531) ,28 Mars 1994 & JP-A-05 344418 (TOSHIBA CORP;OTHERS: 01) 24 Décembre 1993,

## Description

L'invention concerne un circuit de commande automatique de gain comprenant des premiers moyens pour appliquer un gain à un signal d'entrée et pour en déduire un signal de sortie, des seconds moyens pour mesurer la puissance du signal de sortie, des troisièmes moyens pour comparer une valeur dépendant de la puissance mesurée avec une fenêtre de valeurs admises de puissance de référence et pour en déduire un signal de commande pour contrôler le gain appliqué par les premiers moyens.

Un tel circuit de commande automatique de gain est connu de EP-A-0 176 303. EP-A-0 431 435 révèle un autre circuit de commande de gain automatique.

L'invention concerne également un appareil nécessitant l'incorporation d'une commande automatique de gain, par exemple, un récepteur de signaux destiné à recevoir des signaux d'entrée dont l'amplitude varie rapidement sur une grande dynamique. Il s'agit, entre autres, d'un récepteur de signaux modulés par une modulation numérique, par exemple une modulation à sauts de phase (PSK) ou une modulation (MAQ) à sauts de phase et à sauts d'amplitude. Un tel récepteur peut être utilisé en télévision numérique, en téléphonie ou dans d'autres systèmes de transmission numérique ou analogique.

Lorsque les variations d'amplitude d'un signal d'entrée sont importantes, il peut apparaître des difficultés pour adapter l'amplitude du signal d'entrée à la dynamique de l'organe d'entrée du récepteur. Ce problème devient crucial par exemple dans le cas où l'organe d'entrée est un convertisseur analogique-numérique. Il peut arriver des situations pour lesquelles le signal d'entrée sature le convertisseur et d'autres situations pour lesquelles l'amplitude du signal d'entrée est trop faible ce qui conduit à une mauvaise acquisition du signal numérisé. Il est alors nécessaire de contrôler le gain du signal d'entrée à l'aide d'un circuit de commande automatique de gain.

Pour asservir l'amplitude du signal d'entrée à la dynamique de l'organe d'entrée, on utilise couramment un circuit de commande automatique de gain. Pour faire face à l'obtention à la fois de gains élevés et de gains faibles, il existe des circuits munis d'un étage contrôlant les gains élevés et un étage contrôlant les gains faibles. Le document US 4 870 370 concerne une telle situation, l'activation des étages dépendant de l'amplitude du signal d'entrée. Pour cela, on mesure la puissance du signal reçu, puis on compare cette puissance à une fenêtre de valeurs admises de puissance, pour faire intervenir l'un ou l'autre étage selon que la puissance mesurée est dans ou hors de la fenêtre.

En présence de variations d'amplitude importantes et rapides, ce qui est généralement le cas avec des signaux issus d'une modulation numérique, on cherche à éviter que le circuit de commande automatique de gain mette une trop grande durée avant d'atteindre un réglage approprié. En effet, au cours de cette durée, l'acquisition du signal d'entrée est souvent incorrecte.

Le but de l'invention qui est définie dans la revendication 1 est donc de réduire le mieux possible cette durée où l'acquisition est incorrecte.

Ce but est atteint avec un circuit de contrôle automatique de gain pour lequel les moyens pour mesurer la puissance du signal comprennent des moyens de filtrage récursif passe-bas, les moyens pour comparer une valeur dépendant de la puissance mesurée avec une fenêtre de valeurs admises de puissance de référence délivrant un signal d'initialisation qui initialise lesdits moyens de filtrage récursifs avec une valeur de puissance de référence lorsque ladite valeur dépendant de la puissance mesurée est extérieure à la fenêtre de valeurs admises de puissance de référence.

Ainsi avantageusement, lorsque la puissance mesurée s'écarte de la fenêtre de référence choisie, le signal d'initialisation impose au circuit de se réinitialiser sur cette puissance de référence, ce qui permet au circuit d'atteindre rapidement un réglage approprié. Cette puissance de référence est déterminée préalablement en fonction du type d'application concerné.

Préférentiellement, les moyens de filtrage récursif passe-bas comprennent, en cascade, un premier filtre passe-bas ayant une bande passante à transition abrupte caractérisée par une première fréquence de coupure et un second filtre passe-bas de lissage ayant une bande passante caractérisée par une seconde fréquence de coupure inférieure à la première fréquence de coupure. Les fréquences de coupure sont choisies en fonction du type de modulation numérique concerné.

Ainsi avantageusement, le premier filtre élimine sévèrement les composantes haute-fréquence du signal d'entrée ce qui fournit un premier signal de puissance. Celui-ci à son tour est filtré selon un gabarit de filtrage plus progressif pour délivrer le signal de puissance proprement dit. Cette cascade de deux filtres permet de réduire la complexité des moyens matériels nécessaires à l'extraction de l'information de puissance.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :
Figure 1 : un schéma d'un circuit de commande automatique de gain.
Figure 2 : un schéma d'un circuit de commande automatique de gain selon l'invention.
Figure 3 : deux courbes montrant des exemples de gabarits de filtrage des deux filtres passe-bas.
Figure 4 : un schéma du premier filtre passe-bas récursif.
Figure 5 : un schéma du second filtre passe-bas récursif initialisable.

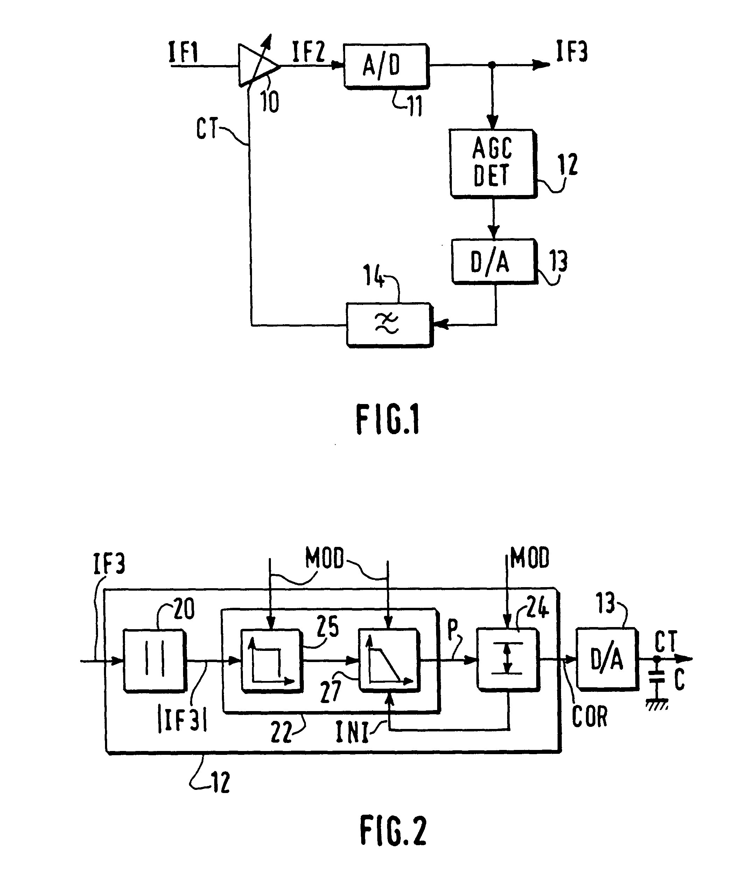

La figure 1 représente un circuit de commande automatique de gain comprenant des moyens d'amplification 10 pour appliquer un gain à un signal d'entrée IF1, par exemple un signal à fréquence intermédiaire modulé par une modulation numérique. Le terme "gain" est utilisé pour désigner à la fois un gain inférieur, supérieur ou égal à l'unité.

A titre d'exemple, considérons le cas où le récepteur effectue un traitement numérique avec des moyens 10 d'amplification réunis à des moyens 11 de conversion analogique-numérique à l'entrée desquels on veut contrôler l'amplitude du signal d'entrée IF2.

Pour permettre au signal d'entrée IF2 soit de ne pas saturer le convertisseur 11, soit d'être trop faible, ce qui entraînerait une conversion analogique-numérique trop imprécise, il est souhaitable de maintenir le signal d'entrée IF2 correctement adapté à la dynamique d'entrée du convertisseur. Pour cela, une boucle de contrôle automatique de gain mesure le signal de sortie IF3 en sortie du convertisseur 11. Cette boucle comprend des moyens 12 pour mesurer la puissance du signal IF3 et pour fournir un signal de commande CT qui agit sur les moyens d'amplification 10. Les moyens 12 constituent un détecteur AGC DET pour la boucle de commande automatique de gain. Les moyens 12 de mesure opérant, dans l'exemple, par traitement numérique, on effectue ensuite une conversion numérique-analogique dans un convertisseur 13 dont le signal de sortie est filtré par des moyens de filtrage passe-bas 14 pour délivrer le signal analogique de commande CT.

Les moyens 12 pour mesurer la puissance du signal IF3 sont représentés sur la figure 2. Ils comprennent, en série, des moyens 20 pour prendre la valeur absolue du signal IF3, des moyens 22 de filtrage passe-bas récursif qui délivrent une puissance moyenne P du signal IF3 et des moyens 24 pour comparer la puissance moyenne P mesurée (ou une valeur dépendant de P) avec une fenêtre de valeurs admises de puissance de référence comprises entre une valeur maximale Pmax et une valeur minimale Pmin. Les moyens 14 de filtrage peuvent être constitués d'une simple capacité C.

Les moyens de comparaison 24 délivrent un signal de correction COR pouvant prendre préférentiellement trois valeurs :
COR = 0 lorsque Pmin ≤ Pm ≤ Pmax
COR = 1 lorsque Pm > Pmax
COR = -1 lorsque Pm < Pmin.

Pour COR = 0, le signal IF2 est correctement adapté à la dynamique d'entrée du convertisseur 11 et le gain des moyens 10 d'amplification ne subit pas de changements.

Pour COR = -1 ou COR = 1, le signal IF2 est incorrectement adapté à la dynamique d'entrée du convertisseur 11. On conçoit que le temps de réaction de la boucle ne doit pas être trop long pour éviter des délais d'intervention trop grands, mais également ne doit pas être trop court au risque de provoquer des changements de gain intempestifs et mal adaptés. Ce risque est particulièrement manifeste avec des signaux d'entrée IF1 issus d'une modulation codée qui présentent de brusques et importantes variations d'amplitude. Pour s'adapter le plus rapidement possible à la dynamique d'entrée du convertisseur pour éviter les risques énoncés, selon l'invention, les moyens 24 de comparaison délivrent en outre un signal d'initialisation INI qui est utilisé pour forcer une valeur Pd de puissance de référence dans les moyens 22 de filtrage récursif. La puissance de référence est située entre les valeurs Pmin et Pmax, par exemple Pd = (Pmin + Pmax) /2. Cette initialisation est rendue possible par la nature récursive des moyens de filtrage 22.

Ce signal d'initialisation est tel que :
INI = 0 lorsque Pmin ≤ Pm ≤ Pmax
INI = 1 lorsque Pm > Pmax ou Pm < Pmin.

Ainsi lorsque la puissance mesurée est à l'extérieur de la fenêtre Pmin-Pmax, le signal INI sert à charger une valeur Pd de puissance de référence dans les moyens 22 de filtrage récursif. La puissance de référence est choisie préalablement en fonction de l'application considérée, du type de modulation par exemple. Un signal de commande MOD peut permettre de sélectionner la taille de la fenêtre, la puissance de référence Pd, ainsi que les fréquences de coupure f₁ et f₂ dans le cas où le système de transmission est prévu pour fonctionner avec différentes modulations numériques.

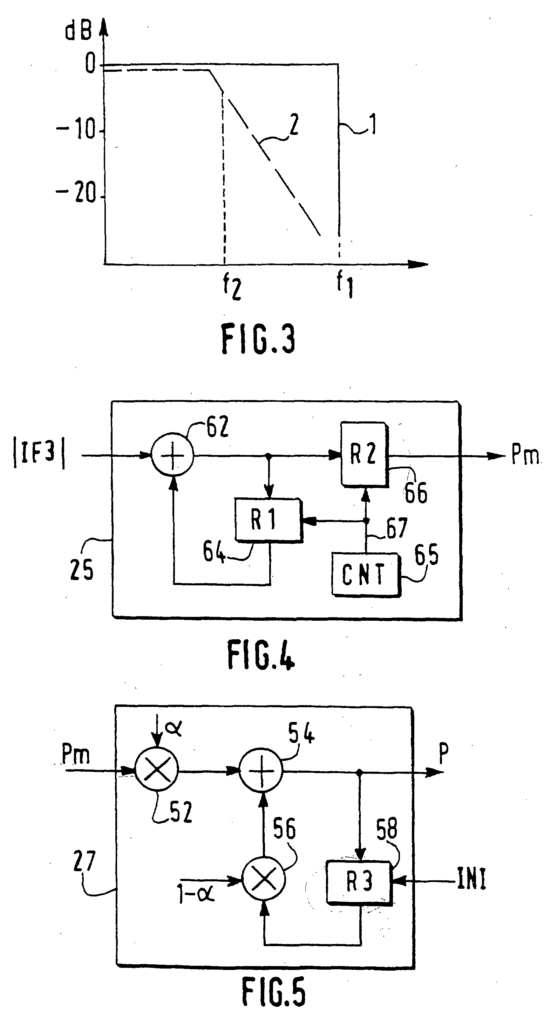

Préférentiellement, les moyens de filtrage 22 comprennent la mise en cascade d'un premier filtre 25 passe-bas ayant une bande passante à transition abrupte suivi d'un second filtre 27 passe-bas ayant une bande passante à transition douce. Les bandes passantes des deux filtres sont par exemple celles représentées sur la figure 3. La transition abrupte du premier filtre (courbe 1) est caractérisée par une fréquence de coupure f₁ (à 3 décibels). La transition douce du second filtre (courbe 2) est caractérisée par une fréquence de coupure f₂ (à 3 décibels) plus faible que la fréquence de coupure f₁. Ainsi, le premier filtre 25 filtre sévèrement les composantes haute-fréquence du signal d'entrée, le signal obtenu étant à son tour lissé par le second filtre 27 pour obtenir une mesure exploitable de puissance. Cette mise en cascade de deux filtres permet au premier filtre de mesurer une puissance moyenne dont les variations sont, elles aussi, éliminées par le second filtre. Les structures des deux filtres peuvent ainsi être simples.

La figure 4 représente un schéma du premier filtre 25. Il comprend un additionneur 62 qui reçoit sur une première entrée la valeur absolue |IF3| du signal IF3 et sur l'autre entrée la sortie de moyens de retard 64, par exemple des registres R1, qui sont connectés sur la sortie de l'additionneur 62. Pour obtenir une mesure de la puissance moyenne sur un horizon de N échantillons, par exemple N=64, une cellule de sortie 66, par exemple des registres R2, délivre une mesure tous les 64 échantillons. Par exemple, avec un signal d'entrée IF1 modulé par une modulation à fréquence-symbole 1/T, les premier 25 et second 27 filtres opèrent à une fréquence 4/T soit quatre fois la fréquence-symbole. Un compteur 65 CNT délivre un signal de comptage 67 à l'issue de blocs de 64 périodes d'horloge 4/T, le signal de comptage extrayant la mesure de puissance moyenne Pm de la cellule de sortie 66 et remettant à zéro les moyens de retard 64 pour permettre au filtre 25 de fournir la mesure suivante de puissance moyenne.

La figure 5 représente un schéma du second filtre 27. Il comprend un premier multiplieur 52 qui reçoit le signal de puissance moyenne Pm à filtrer et un coefficient α. La sortie du premier multiplieur 52 est reliée à une entrée d'un additionneur 54 qui reçoit sur une autre entrée la sortie d'un second multiplieur 56. Celui-ci est placé dans une boucle qui comprend également des moyens de retard 58, par exemple des registres R3. La sortie de l'additionneur 54 délivre le signal de puissance moyenne filtré P à comparer à la fenêtre de valeurs admises. Pour former la boucle récursive, le signal P entre dans les moyens de retard 58 dont la sortie est réunie à une entrée du multiplieur 56 qui lui-même a une autre entrée recevant un coefficient 1-α. Pour initialiser avec la puissance Pd de référence, on charge dans les moyens de retard 58 la valeur de puissance de référence à l'aide du signal d'initialisation INI. On peut par exemple charger un mot binaire dans des registres formant les moyens de retard 58. Les multiplieurs et l'additionneur peuvent être respectivement des moyens de multiplication et des moyens d'addition par exemple à structure intégrée.

Le circuit de commande automatique de gain (analogique) permet de commander des amplitudes des signaux IF2 et IF3 (numérique). Il est possible de commander l'amplitude du signal IF2 en n'effectuant pas de conversion 11 analogique-numérique ni de conversion 13 numérique-analogique et en réalisant les autres fonctions en analogique.

## Revendications

1. Circuit de commande automatique de gain comprenant des premiers moyens (10) pour appliquer un gain à un signal d'entrée et pour en déduire un signal de sortie, des seconds moyens (20, 22) pour mesurer la puissance du signal de sortie, des troisièmes moyens (24) pour comparer une valeur dépendant de la puissance mesurée avec une fenêtre de valeurs admises de puissances de référence, et pour en déduire un signal de commande (CT) pour contrôler le gain appliqué par les premiers moyens (10), **caractérisé en ce que** les seconds moyens (22) comprennent des moyens (25, 27) de filtrage récursif passe-bas, les troisièmes moyens (24) délivrant en outre un signal d'initialisation (INI) qui initialise lesdits moyens de filtrage récursifs (27) avec une valeur de puissance de référence (Pd) lorsque ladite valeur dépendant de la puissance mesurée est extérieure à la fenêtre de valeurs admises de puissances de référence.

2. Circuit selon la revendication 1 **caractérisé en ce que** les moyens de filtrage récursif comprennent en cascade un premier filtre (25) passe-bas ayant une bande passante à transition abrupte **caractérisée par** une première fréquence de coupure et un second filtre (27) passe-bas de lissage, ayant une bande passante **caractérisée par** une seconde fréquence de coupure inférieure à la première fréquence de coupure.

3. Circuit selon les revendications 1 ou 2 **caractérisé en ce que** le signal d'entrée est issu d'une modulation numérique.

4. Récepteur de signaux **caractérisé en ce qu'**il comprend un circuit de commande automatique de gain selon une des revendications 1 à 3.

## Patentansprüche

1. Schaltung zur automatischen Verstärkungsregelung und erste Verfahren (10) zur Vornahme einer Verstärkung an einem Eingangssignal und zur Ableitung davon eines Ausgangssignals, zweite Verfahren (20, 22) zur Messung der Leistung des Ausgangssignals, dritte Verfahren (24) zum Vergleichen eines von der gemessenen Leistung abhängenden Wertes mit einem Werterahmen zulässiger Bezugsleistungen und zur Ableitung davon eines Regelsignals (CT) zur Steuerung der von den ersten Verfahren (10) vorgenommenen Verstärkung, **dadurch gekennzeichnet, daß** die zweiten Verfahren (22) Verfahren (25, 27) zur rekursiven Tiefpaßfilterung enthalten, die dritten Verfahren (24) zudem ein Initialisierungssignal (INI) abgeben, das die besagten rekursiven Filterverfahren (27) mit einem Bezugsleistungswert (Pd) initialisiert, wenn der besagte, von der gemessenen Leistung abhängende Wert außerhalb des Werterahmens zulässiger Bezugsleistungen liegt.

2. Schaltung nach Anspruch 1, **dadurch gekennzeichnet, daß** die rekursiven Filterverfahren in Kaskade einen ersten Tiefpaßfilter (25) mit einer abrupt übergehenden Bandbreite, durch eine erste Grenzfrequenz gekennzeichnet, und einen zweiten, glättenden Tiefpaßfilter (27) mit einer Bandbreite enthalten, durch eine zweite Grenzfrequenz gekennzeichnet, die unter der ersten Grenzfrequenz liegt.

3. Schaltung nach einem der Ansprüche 1 oder 2, **dadurch gekennzeichnet, daß** das Eingangssignal aus einer digitalen Modulation kommt.

4. Signalempfänger, **dadurch gekennzeichnet, daß** er eine automatischen Verstärkungsregelung nach einem der Ansprüche 1 bis 3 enthält.

## Claims

1. An automatic gain control circuit comprising first means (10) for applying a gain to an input signal and for deriving therefrom an output signal, second means (20)(22) for measuring the power of the output signal, third means (24) for comparing a value in relation with the measured signal power with a window of permitted reference power values and for deriving therefrom a control signal (CT) for checking the gain applied by the first means (10), **characterized in that** the second means (22) comprise low-pass recursive filter means (25)(27), while the third means (24) furthermore produce an initialization signal (INI) which initializes said recursive filter means (27) with a reference power value (Pd) when said value, which depends on the measured power, lies outside the window of permitted reference power values.

2. A circuit as claimed in Claim 1, **characterized in that** the recursive filter means comprise in a cascaded combination a first low-pass filter (25) which has a passband with an abrupt transition **characterized by** a first cut-off frequency, and a second low-pass smoothing filter (27) which has a passband **characterized by** a second cut-off frequency which is lower than the first cut-off frequency.

3. A circuit as claimed in Claim 1 or 2, **characterized in that** the input signal comes from a digital modulation

4. A signal receiver, **characterized in that** it comprises an automatic gain control circuit as claimed in one of the Claims 1 to 3.
